# EUROPEAN PATENT APPLICATION

(11) **EP 1 043 626 A1**
(43) Date of publication of application: **11.10.2000**
(21) Application number: 99830195.6
(22) Date of filing: 06.04.1999
(51) Int. Cl.: G03F 1/14, G03F 7/20

(54) **A method for improving the performance of photolithographic equipment and for increasing the lifetime of the optics thereof**

(71) Applicant: STMicroelectronics S.r.l., 20041 Agrate Brianza (Milano) (IT)
(72) Inventor: Romeo, Carmelo, 20059 Vimercate (MI) (IT); Canestrari, Paolo, 22055 Merate (LC) (IT); Ruffoni, Roberto, 20046 Biassono (MI) (IT)
(74) Representative: Mittler, Enrico

(57) **Abstract**

In a photolithographic process using a photolithographic mask having opaque mask areas and transparent mask areas, the opaque mask areas corresponding to a pattern to be transferred onto a semiconductor wafer to form on the wafer a pattern of active structures, a method for improving the performance of the photolithographic equipment and for increasing the lifetime of the optics thereof characterized by providing auxiliary opaque mask areas (2;3;4) in areas of the mask not covered by active opaque mask areas (1), so as to reduce a transmission factor of the mask.

## Description

The present invention relates to semiconductor technology. Particularly, the invention concerns a method for improving the performance of photolithographic equipment used in semiconductor device manufacturing, and for increasing the lifetime of the optics of the photolithographic equipment.

For the manufacturing of semiconductor devices, photolithography is widely employed. By this technique, selected regions of a semiconductor wafer can be doped, or a desired pattern can be formed in a particular layer of the wafer, such as a polysilicon layer, a dielectric layer, and a metal layer.

In the photolithographic process, a layer of a material sensitive to a light radiation is firstly deposited over the wafer; such material is called photoresist. Then, the wafer is exposed to the light radiation generated by a light source with the interposition of a photolithographic mask reproducing the pattern to be formed in the photoresist. The photolithographic mask is partially light transmitting, in the sense that it comprises dark or opaque areas and transparent areas. The pattern to be formed in the photoresist that is reproduced on the mask is made up of opaque mask areas, while the transparent mask areas correspond to the portions of the photoresist layer which are to be removed.

During the exposition of the wafer, the light coming from the light source is concentrated onto the mask. By means of an optical system comprised of a plurality of lenses (which in the following will be referred to as "the lens", for the sake of simplicity), the aerial image of the mask is thus projected onto the wafer with a reduction factor typically of 5x or 4x. The projection system allows to precisely focusing the mask aerial image onto the wafer. The light radiation passing through the transparent mask areas will thus hit the photoresist, while the portions of the photoresist under the opaque mask areas will not be exposed to the light radiation.

During a subsequent selective etch process, the portions of the photoresist layer which have been exposed to the light radiation will be removed, and only those regions of the photoresist which have not been exposed to the light radiation will be left, thus forming the desired pattern on the wafer.

The interaction of the light radiation with the lens of the optical system produces effects that can negatively affect the precision of the pattern transferred onto the wafer.

A first effect is due to the light that is back diffused from the wafer. As mentioned, the light coming from the light source and passing through the lens exposes the regions of the wafer wherein the photoresist is to be selectively removed. If such regions are wide, a decrease of the contrast is experienced. In fact, despite the lens is provided with an anti-reflecting film, a fraction of the reflected light creates a diffused radiation also in those regions, which would not to be exposed to the light. Additionally, the light projected onto the wafer is back reflected, contributing by the previous mechanism to the reflected radiation.

A second effect is due to the lens heating. Especially in some manufacturing process steps wherein high exposure energies are involved, the light radiation produces a heating of the lens. This has two negative consequences: firstly, if the lens temperature increases, the mask image projected onto the wafer will not be focused anymore. For example, if several wafers are exposed in succession, only on the first ones the mask image will be focused, while on the remaining ones the image would be degraded. In addition, the lens' aberration is negatively affected by the lens' heating. All this negatively impacts the process control and the stochastic dispersion of the dimensions of the resist structures. Secondly, the heating of the lens could permanently damage the same, such a damaging caused by a damaging of both the protective films (coating) of the lens and the material forming the lens. For instance, a high power pulsed radiation generated by a laser, in the wavelength range of 248 to 193 nm, induces the formation of color centers in the quartz composing the lens. In the color centers the high temperature caused by a strong light absorption modifies the refraction index and causes aberrations of the image. In some cases, mainly when small wavelength are used, the crystal lattice of the quartz forming the lens can be permanently modified (compaction or microchannelling).

In view of the state of the art described, it has been an object of the present invention that of providing a method for improving the performance of the photolithographic equipment and for increasing the lifetime of the optics thereof.

According to the present invention, such an object has been attained by means of a method for improving the performance of the photolithographic equipment and for increasing the lifetime of the optics thereof characterized by providing auxiliary opaque mask areas in areas of the mask not covered by active opaque mask areas, so as to reduce a transmission factor of the mask.

The features and advantages of the present invention will be made apparent by the following detailed description of some embodiments thereof, illustrated by way of non-limiting examples in the annexed drawings, wherein:
Figure 1 schematically shows in top-plan view a mask projected image including an auxiliary structure according to a first embodiment of the invention;
Figure 2 schematically shows in top-plan view a mask projected image including an auxiliary structure according to a second embodiment of the present invention; and
Figure 3 schematically shows in top-plan view a mask projected image including an auxiliary structure according to a third embodiment of the present invention.

The basic idea underlying the present invention is to decrease the transmission factor of a generic photolithographic mask. As mentioned in the previous discussion of the background art, a generic photolithographic mask generally comprises dark areas, i.e., areas not transparent to the light radiation, and transparent areas. The opaque mask areas define the geometry of the structures which are to be formed in a, e.g., photoresist layer on the surface of the wafer, in that after the exposure to the light radiation a selective etch process will remove the photoresist layer in all those areas where it has been exposed to the light. Conventionally, the opaque mask areas strictly correspond to the layout of the structures to be formed in the photoresist layer, and all the other areas of the mask are transparent to the light (that means that all the photoresist layer will be removed except where a structure functional for the device to be manufactured is to be formed). The opaque mask areas correspond in a sense to "active" structures on the wafer.

Starting from these considerations, the Applicant recognized that in order to decrease the transmission factor of a generic mask, "auxiliary" dark areas can be provided for in those regions of the mask which conventionally are made transparent, i.e. in those regions of the mask not covered by the layout of the structure to be formed in the photoresist layer.

This allows for a decrease in the transmission factor of the mask, and eliminates or at least significantly reduces the negative effects previously discussed.

After the exposure to the light source and the selective etch process, the photoresist layer will be left not only where active device structures are to be formed, but also in correspondence of the auxiliary dark areas of the mask.

Clearly, the provision of the auxiliary dark areas must not affect the functionality of the device to be manufactured, i.e., the auxiliary structures which will be formed in the chip must not affect the active structures. However, the auxiliary structures could be electrically connected to the active structures, for example they could be connected to ground.

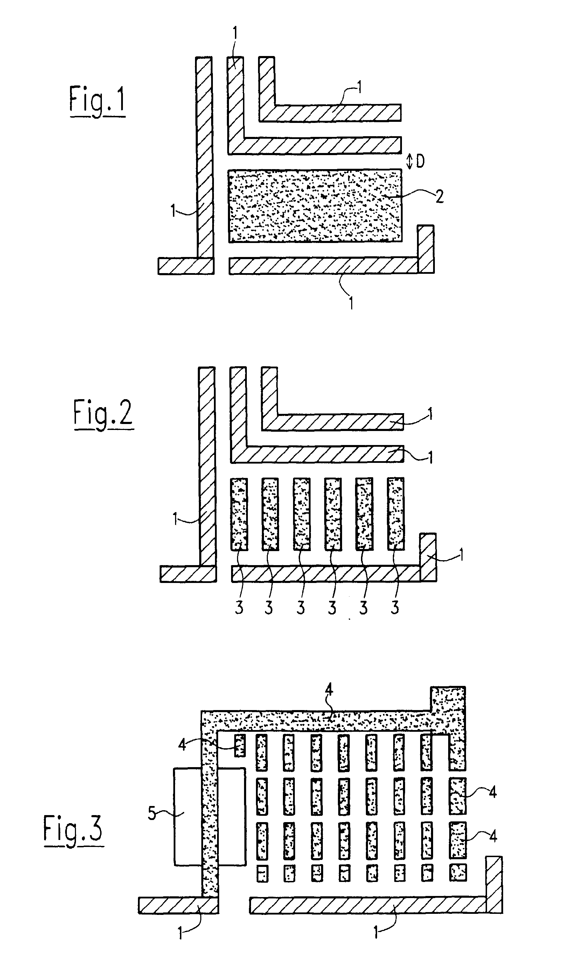

Figure 1 schematically shows in top-plan view an image of a photolithographic mask (actually, a portion of a photolithographic mask) including active structures 1 and, in a region not covered by the active structures 1, an auxiliary structure 2. The provision of the auxiliary structure 2, which is an auxiliary opaque mask area, in a region where conventionally would be completely transparent to the light radiation, allows for a significant reduction of the problems due to diffused radiation and lens heating, thus contributing to a more precise definition of the active structures on the wafer and to an increase of the lifetime of the optics of the photolithographic equipment. Clearly, the auxiliary structures must comply with the general layout rules, for example in terms of minimum distance (D) of the auxiliary structures from the active structures.

Figure 2 schematically shows in top-plan view an image of a photolithographic mask (or portion thereof) including the same active structures 1 as the mask of Figure 1, and a slightly different auxiliary structure 3. The difference is that, instead of providing a single, continuous auxiliary structure covering the area not covered by the active structures, a fractionated auxiliary structure 3 is formed. However, the result achieved is substantially the same as that in Figure 1. This solution can be adopted whenever a single auxiliary structure is not allowed due to layout rules and/or electrical reasons.

In principle, any shape for the auxiliary structures can be chosen, provided that the layout rules are complied with.

Figure 3 schematically shows in top-plan view an image of a photolithographic mask (or portion thereof), projected onto a wafer, including again active structures 1 and an auxiliary structure 4 in area not covered by the active structures. An underlying layer 5 of the wafer is also schematically shown. The auxiliary structure 4 is designed to comply with layout rules posed by the underlying layer 5. In general, if the presence of underlying layers dictates layout rules for the overlying layer, then the auxiliary structures must be designed to comply with such rules, for example in terms of minimum distance.

A further possibility to implement the present invention resides in the extension of the active structures of the device, to cover all or a significant part of the conventionally transparent mask areas.

## Claims

1. In a photolithographic process using a photolithographic mask having opaque mask areas and transparent mask areas, the opaque mask areas corresponding to a pattern to be transferred onto a semiconductor wafer to form on the wafer a pattern of active structures, a method for improving the performance of the photolithographic equipment and for increasing the lifetime of the optics thereof characterized by providing auxiliary opaque mask areas (2;3;4) in areas of the mask not covered by active opaque mask areas (1), so as to reduce a transmission factor of the mask.
